Europäisches Patentamt

European Patent Office

Office européen des brevets

(11) Publication number: **0 500 093 A1**

# EUROPEAN PATENT APPLICATION

(21) Application number: **92102829.6**

(22) Date of filing: **20.02.92**

(51) Int. Cl.⁵: **C04B 35/76**, C04B 35/74, H01L 23/15

(30) Priority: **20.02.91 JP 45559/91**

(43) Date of publication of application:
**26.08.92 Bulletin 92/35**

(84) Designated Contracting States:
**DE FR GB NL**

(71) Applicant: SUMITOMO ELECTRIC INDUSTRIES,
LTD.
5-33, Kitahama 4-chome, Chuo-ku
Osaka-shi, Osaka 541(JP)

(72) Inventor: **Shimoda, Kouhei, c/o Itami Works of
Sumitomo
Electric Industries, Ltd, 1-1 Koyakita
1-chome
Itami-shi, Hyogo(JP)**
Inventor: **Sogabe, Koichi, c/o Itami Works of
Sumitomo
Electric Industries, Ltd, 1-1 Koyakita
1-chome
Itami-shi, Hyogo(JP)**
Inventor: **Nishioka, Takao, c/o Itami Works of
Sumitomo
Electric Industries, Ltd, 1-1 Koyakita
1-chome
Itami-shi, Hyogo(JP)**
Inventor: **Matsunuma, Kenji, c/o Itami Works
of Sumitomo
Electric Industries, Ltd, 1-1 Koyakita
1-chome
Itami-shi, Hyogo(JP)**

(74) Representative: **Fiener, Josef
Patentanwälte Kahler, Käck & Fiener,
Gerberstrasse 3, Postfach 12 49
W-8948 Mindelheim(DE)**

(54) **Ceramic composite material and process for producing the same.**

(57) Disclosed is ceramic composite material comprising a ceramic as a matrix mainly composed of any one member selected from among $Al_2O_3$, $ZrO_2$, $SiO_2$, AlN, $Si_3N_4$, h-BN, $TiB_2$, $ZrB_2$, $Al_4C_3$, SiC, TiC, mullite and composites thereof and containing metallic reinforcement therein in amount of 50% by weight or less, based on the total weight of the ceramic and the metallic reinforcement; and a process for producing the ceramic composite material wherein sintering is conducted after molding is conducted with a doctor blade, or by extrusion, slip casting or press molding. The ceramic composite material has an improved toughness through the use of the metallic reinforcement.

## BACKGROUND OF THE INVENTION

### 1. Field of the Invention

The present invention relates to a ceramic composite material having an advantage inherent in the ceramic, such as the lightness in weight, and, at the same time, remedied in the fragility which is a drawback of the ceramic. More particularly, the present invention relates to a high-strength, high toughness ceramic composite material comprising as a matrix a ceramic used in electronic materials including IC boards and packaging materials and structural materials for engine components of automobiles and, incorporated therein, a metallic fiber, a punching metal, etc.

### 2. Description of the Prior Art

Various studies have been made on the compositing of ceramics mainly for the purpose of remedying the fragility, that is, enhancing the toughness. In order to enhance the toughness, it is necessary to improve the fracture energy. The utilization of phase transformation, such as addition of $Y_2O_3$ to $ZrO_2$, the separation of particles different from the matrix in the physical properties (particle dispersion reinforcement), the compositing of a whisker (whisker dispersion reinforcement), etc., have been widely used for this purpose.

In the method wherein the phase transformation is utilized, however, the type of the ceramic used is limited, so that the ceramic used does not always fit to the properties required of the material.

Further, heat resistance is necessary when high temperature properties are taken into consideration. For this reason, a ceramic whisker of silicon nitride, silicon carbide or the like is often used as a reinforcement. In this case, the matrix and the compositing material themselves should have excellent heat resistance. At the same time, it is important to select a combination capable of attaining the enhancement of the toughness from the above-described materials satisfying the heat resistance requirement.

However, for example, in the selection of a combination of silicon nitride with silicon carbide excellent in heat resistance, the physical properties of both the materials are so similar to each other that it is impossible to effectively utilize a toughness enhancement mechanism through the storage of internal strain. No marked enhancement in the toughness can be attained as known in the case of a silicon nitride sintered body containing silicon carbide particles dispersed therein. Further, since the ceramic is a material which is difficult to form into fiber, the type and configuration of the ceramic whisker and ceramic fiber are limited, so that the ceramic does not always fit to the necessary properties. Further, it is difficult to produce ceramic whisker and ceramic fiber with uniform thickness, and the homogeneity is poor. Therefore, a ceramic composite wherein the ceramic whisker or ceramic fiber is used as a reinforcement lacks in the uniformity of the properties such as strength and is poor in the reliability of the material. Further, the production cost of the ceramic whisker and ceramic fiber is so high that these materials have many problems in respect of the profitability.

## SUMMARY OF THE INVENTION

The present invention provides a ceramic composite material comprising a ceramic as a matrix mainly composed of one member selected from among $Al_2O_3$, $ZrO_2$, $SiO_2$, AlN, $Si_3N_4$, h-BN, $TiB_2$, $ZrB_2$, $Al_4C_3$, SiC, TiC, mullite and composites thereof and containing therein in amount of 50% by weight or less, based on the total weight of the ceramic and the metallic reinforcement. Preferably the metallic reinforcement comprises 90% by weight or more of at least one member selected from among W, Mo and Ta and is in the form of at least one selected from among a metallic plate, a punching metal, a metal wire, a filamentous metal and a metallic mesh.

The above-specified ceramic composite material of the present invention can be produced in accordance with the following processes, using the above-mentioned matrix ceramic material and the reinforcement material. One of the processes comprises molding ceramic powder with a doctor blade or by extrusion, laminating the resulting molding together with a metallic reinforcement and firing the laminate. Another process is slip casting which comprises slurrying ceramic powder through the use of a binder, a solvent, etc., and casting the slurry into a mold, wherein sintering is conducted after a metallic reinforcement is put in a mold so that the metallic reinforcement is buried in a molding. A still another process is press molding which comprises preparing a complete powder through the use of ceramic powder with or without the addition of a binder and a plasticizer and subjecting the powder to press molding in a mold, wherein sintering is conducted after a metallic reinforcement is put in a mold so that the metallic reinforcement is buried in a molding.

The amount of the reinforcement is 50% or less based on the total weight of the ceramic powder and the metallic reinforcement.

## DETAILED DESCRIPTION OF THE PREFERRED EMBODIMENTS

In the ceramic composite material of the present invention, since the metallic reinforcement provides excellent ductility and heat resistance preferably by the use of W, Mo or Ta, and the matrix being a ceramic having physical properties different from those of the reinforcement, the ceramic composite material can have a high toughness and a high heat conductivity by virtue of the utilization of a toughness enhancement mechanism through the storage of internal strain, the utilization of the ductility of the metal, excellent heat conductivity, etc., without detriment to the advantage inherent in the ceramic, such as the lightness in weight. Further, since the metallic reinforcement is deformable, when an externally applied stress disperses and propagates around the metallic reinforcement and is conveyed to the metallic reinforcement, the stress passes through the reinforcement, propagates for and disperses widely, which contributes to an improvement in the toughness value and, at the same time, a remarkable improvement in the mechanical impact resistance. Further, since the metallic reinforcement is incorporated within the matrix, the excellent abrasion resistance of the matrix ceramic is not impaired.

The content of the metallic reinforcement is set to be 50% by weight or less, based on the total weight of the ceramic as the matrix and the metallic reinforcement, because when the content exceeds 50% by weight, it becomes difficult to produce a dense sinter, so that the strength and toughness lower. The content of the preferred materials, which are W, Mo and Ta in the metallic reinforcement is set to be 90% by weight or more, based on the weight of the metallic reinforcement, because when the content is less than 90% by weight, the heat resistance lowers and the metallic reinforcement becomes fragile during sintering, so that no effect derived from compositing can be attained.

According to the present invention, after the ceramic powder is molded with a doctor blade or by extrusion, the resulting molding is laminated together with a metallic reinforcement to bury the reinforcement in the molding. Alternatively, the metallic reinforcement is buried in the molding in the step of molding in the slip casting or press molding. Therefore, it is possible to produce a sintered body without significant defect such as void.

Examples of the binder used in the molding include paraffins and further resins such as PVA (polyvinyl alcohol) and PVB (polyvinyl butyral). If necessary, it is also possible to use a plasticizer. Examples of the solvent include water and further organic solvents such as toluene and ethyl alcohol.

In the ceramic composite material of the present invention and the process for producing the same, if necessary, an additive, such as sintering assistant, can be added to the matrix ceramic.

If necessary, the metallic reinforcement may be subjected to a surface treatment such as gas nitriding, liquid nitriding (salt bath nitriding) or soft nitriding (tufftriding). Further, if necessary, the metallic reinforcement may be etched to protrude part of the metallic reinforcement into the matrix ceramic.

The present invention will now be described in more detail with reference to the following Examples and comparative Examples.

Example 1

89% by weight of $\alpha$-silicon nitride having a mean grain diameter of 0.7 $\mu$m, 7% by weight of yttria having a mean grain diameter of 1.0 $\mu$m and 4% by weight of alumina having a mean grain diameter of 0.5 $\mu$m were compounded with each other, mixed in a ball mill for 24 hr and spray-dried to prepare a complete powder. In order to bury a molybdenum mesh in a press molding, a molybdenum mesh having a purity of 99% was put in a press mold, and press molding was conducted at 0.8 ton/cm$^2$. The resultant molding was sintered at 1670°C in a nitrogen atmosphere under atmospheric pressure to prepare a ceramic composite. The density of the sintered body was measured according to JIS C 2141 and found to be 3.83 g/cm$^3$. Further, the fracture strength was measured by the three-point bending method according to JIS R 1607 and found to be as high as 165 kg/mm$^2$. The fracture toughness value ($K_{1c}$) was determined according to JIS R 1607 as follows. For fracture toughness ($K_{1c}$) measurement, use was made of a test piece having the same size as that of a test piece for fracture strength measurement, and a V groove having a width of 0.1 mm and a depth of 0.75 mm was formed by means of a diamond cutter at the center of the test piece. The fracture toughness was then determined at room temperature under the conditions of a span of 30 mm and a crosshead speed of 0.75 mm/min and found to be as high as 10.6 MPa•m$^{1/2}$.

Comparative Example 1

A powder having the same composition as that of the Example 1 was sintered in the same manner as that of the Example 1, except that no molybdenum mesh was buried. The resultant sintered body had a density of 3.20 g/cm$^3$, a fracture strength of 92 kg/mm$^2$ and a fracture toughness value ($K_{1c}$) of 5.9 MPa•m$^{1/2}$.

Example 2

The same silicon nitride, yttria and alumina as those of the Example 1 in respective amounts of 93% by weight, 5% by weight and 2% by weight were compounded with each other and then mixed in a ball mill for 24 hr. The resultant slurry was degassed and then molded with a doctor blade into a green sheet having a thickness of 0.8 mm. A tantalum mesh was sandwiched between the green sheets, and lamination was conducted while heating at 120°C. The laminate was sintered under atmospheric pressure and then hot-pressed at 1750°C. The sintered body had a density of 3.90 $g/cm^3$, a fracture strength of 180 $kg/mm^2$ and a fracture toughness value ($K_{1c}$) of 10.8 MPa•$m^{1/2}$.

Example 3

90% by weight of alumina having a mean grain diameter of 2.5 $\mu$m, 6% by weight of talc and 4% by weight of clay were compounded with each other and then mixed for 24 hr in a ball mill through the use of an alumina pot and an alumina ball. A polyvinyl butyral resin (PVB) was added thereto, and the mixture was subjected to ball milling for 24 hr. The resultant slurry was degassed and molded with a doctor blade into a green sheet having a thickness of 0.8 mm. Some tungsten wires each having a diameter of 0.35 mm were sandwiched between the green sheets, and lamination was conducted while heating at 120°C. The laminate was sintered at 1600°C in a humidified hydrogen/nitrogen mixture atmosphere. The sintered body had a density of 4.63 $g/cm^3$, a fracture strength of 85 $kg/mm^2$ and a fracture toughness value ($K_{1c}$) of 7.8 MPa•$m^{1/2}$.

Example 4

95% by weight of aluminum nitride having a mean grain diameter of 1.1 $\mu$m and 5% by weight of yttria having a mean grain diameter of 1.0 $\mu$m were compounded with each other, mixed in a ball mill for 24 hr and spray-dried to prepare a complete powder. In order to bury a molybdenum mesh in a press molding, a molybdenum mesh having a purity of 99% or more was put in a press mold, and press molding was conducted at 1.0 ton/$cm^2$. The resultant molding was sintered at 1800°C in a nitrogen atmosphere under atmospheric pressure. The sintered body had a density of 3.66 $g/cm^3$, a fracture strength of 90 $kg/mm^2$ and a fracture toughness value ($K_{1c}$) of 8.0 MPa•$m^{1/2}$.

The ceramic composite material of the present invention has attained an improvement in the toughness, that is, a task of the conventional ceramic, through the use of a metallic reinforcement. Further, the present invention provides a process for producing the composite material easily, which renders the present invention very useful from the industrial viewpoint.

**Claims**

1. A ceramic composite material comprising a ceramic as a matrix mainly composed of one member selected from among $Al_2O_3$, $ZrO_2$, $SiO_2$, AlN, $Si_3N_4$, h-BN, $TiB_2$, $ZrB_2$, $Al_4C_3$, SiC, TiC, mullite and composites thereof and containing a metallic reinforcement therein in amount of 50% by weight or less, based on the total weight of said ceramic and said metallic reinforcement.

2. A ceramic composite material according to claim 1, wherein said metallic reinforcement comprises 90% by weight or more, based on the total weight of said metallic reinforcement, of at least one member selected from among W, Mo and Ta.

3. A ceramic composite material according to claim 1 or 2 , wherein said metallic reinforcement is in the form of at least one selected from among a metallic plate, a punching metal, a metal wire, a filamentous metal and a metallic mesh.

4. A process for producing a ceramic composite material, characterized by molding ceramic powder mainly composed of one member selected from among $Al_2O_3$, $ZrO_2$, $SiO_2$, AlN, $Si_3N_4$, h-BN, $TiB_2$, $ZrB_2$, $Al_4C_3$, SiC, TiC, mullite and composites thereof with a doctor blade or by extrusion, laminating the molding together with a metallic reinforcement in an amount of 50% by weight or less, based on the total weight of said ceramic powder and said metallic reinforcement and firing the laminate.

5. A process for producing a ceramic composite by slip casting which comprises slurrying ceramic powder through the use of a binder, a solvent, etc., and casting the slurry into a mold to provide a molding, characterized by putting a metallic reinforcement in an amount of 50% by weight or less, based on the total weight of said ceramic powder and said metallic reinforcement, in a mold so that said metallic reinforcement is buried in said molding and then conducting sintering, wherein said ceramic powder is mainly composed of one member selected from among $Al_2O_3$, $ZrO_2$, $SiO_2$, AlN, $Si_3N_4$, h-BN, $TiB_2$, $ZrB_2$, $Al_4C_3$, SiC, TiC, mullite and composites thereof.

6. A process for producing a ceramic composite by press molding which comprises preparing a complete powder through the use of ceramic powder with or without the addition of a binder and a plasticizer and subjecting said powder to press molding in a mold to provide a molding, characterized by putting a metallic reinforcement in an amount of 50% by weight or less, based on the total weight of said ceramic powder and said metallic reinforcement, in a mold so that said metallic reinforcement is buried in said molding and then conducting sintering, wherein said ceramic powder mainly composed of one member selected from among $Al_2O_3$, $ZrO_2$, $SiO_2$, AlN, $Si_3N_4$, h-BN, $TiB_2$, $ZrB_2$, $Al_4C_3$, SiC, TiC, mullite and composites thereof.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | GB-A-674 152 (FULMER RESEARCH INSTITUTE LTD.) 18 June 1952 <br> * the whole document * <br> --- | 1-3,5,6 | C04B35/76 <br> C04B35/74 <br> H01L23/15 |
| X | GB-A-1 151 464 (TRW INC.) 7 May 1969 <br> * the whole document * <br> --- | 1-3,6 | |
| X | US-A-4 276 331 (B.E. BOTHWELL) 30 June 1981 <br> * column 8, line 28 - column 11, line 14; claims 1-5; figures 3-6 * <br> --- | 1,3,4,5 | |
| X | US-A-4 209 560 (T. VASILOS) 24 June 1980 <br> * column 1, line 45 - column 2, line 3; claims 1-6; figure 1 * <br> --- | 1-3,6 | |
| X | DE-A-1 471 152 (FELDMÜHLE AG) 5 December 1968 <br> * claims 1-3 * <br> --- | 1-3 | |
| X | DE-A-2 753 198 (U.S. ENERGY RESEARCH AND DEVELOPMENT ADMINISTR.) 1 June 1978 <br> * claims 1-6 * <br> ----- | 1-3 | |

**TECHNICAL FIELDS SEARCHED (Int. Cl.5)**

C04B

The present search report has been drawn up for all claims

| Place of search | Date of completion of the search | Examiner |
|---|---|---|
| THE HAGUE | 25 MAY 1992 | LUETHE H. |